# FASCICULE DE BREVET EUROPEEN

(11) **EP 3 014 661 B1**
(45) Date de publication et mention de la délivrance du brevet: **12.07.2017**
(21) Numéro de dépôt: 14735519.2
(22) Date de dépôt: 26.06.2014
(51) Int. Cl.: H02S 40/42, H02S 40/22

(54) **MODULE SOLAIRE A REGULATION DU NIVEAU D'HUMIDITE SIMPLIFIE**
SOLARMODUL MIT VEREINFACHTER FEUCHTIGKEITSPEGELREGULIERUNG
SOLAR MODULE WITH SIMPLIFIED HUMIDITY LEVEL REGULATION

(30) Priorité: 26.06.2013 FR 1356157
(43) Date de publication de la demande: 04.05.2016
(73) Titulaire: Commissariat à l'Énergie Atomique et aux Énergies Alternatives, 75015 Paris (FR); Heliotrop, 69003 Lyon (FR)
(72) Inventeur: MARIOTTO, Mathieu, 38190 Villard-Bonnot (FR); BAUDRIT, Mathieu, F-73000 Chambery (FR); BELLAVOINE, Paul, F-75016 Paris (FR); DE SALINS, Jean Edouard, F-75014 Paris (FR); DEGABRIEL, Florian, F-38600 Fontaine (FR); LAFERRIERE, Philippe, F-75008 Paris (FR)
(74) Mandataire: Brevalex
(86) Numéro de dépôt international: PCT/EP2014/063591
(87) Numéro de publication internationale: WO 2014/207141

(56) Documents cités:
- US-A- 4 633 032
- US-A- 5 384 653
- US-A1- 2008 000 195
- US-A1- 2009 173 376
- US-A1- 2012 031 465
- US-A1- 2013 036 909

## Description

### DOMAINE TECHNIQUE ET ART ANTÉRIEUR

La présente invention se rapporte à un module solaire à régulation du niveau d'humidité simplifié.

Les systèmes photovoltaïques à concentration connaissent un développement important du fait de l'augmentation significative des rendements des cellules triples jonctions qu'ils utilisent pour convertir l'énergie solaire concentrée en énergie électrique.

Un système photovoltaïque à concentration comporte des modules formés d'un caisson dont le fond supérieur est formé d'une ou plusieurs lentilles de Fresnel qui concentrent le flux solaire incident et le fond inférieur sert de support à une ou plusieurs cellules photovoltaïques. Le système comporte un châssis mobile appelé "tracker" sur lequel sont disposés un ou plusieurs modules ; le châssis se déplace pour suivre la trajectoire du soleil de telle sorte que les rayons solaires soient toujours perpendiculaires aux lentilles.

Le rayonnement solaire direct est concentré par les lentilles et est transmis aux cellules photovoltaïques qui le convertissent en énergie électrique.

Le rayonnement des lentilles vers le ciel nocturne dégagé entraîne une diminution importante de la température des lentilles, qui, lorsqu'elle passe en dessous de la température de rosée de l'air qui est contenu dans le caisson, engendre l'apparition d'une première goutte d'eau liquide. Les lentilles présentent sur leur face intérieure une microstructure dentelée qui est le siège privilégié du mécanisme de condensation liquide et de piégeage du condensat formé.

Il se forme donc une pellicule d'eau liquide ou solide sur la surface intérieure des lentilles, qui empêche la production d'électricité du fait du rayonnement direct nul; le rendement global du système est donc fortement dégradé. En outre, il en résulte un risque de corrosion composants électriques et d'autres modes de dégradations des matériaux du module par le condensat; la durée de vie et la fiabilité du système sont alors réduites de manière importante.

Par ailleurs, le facteur de concentration des systèmes de plus en plus grand, par exemple 1000 fois le soleil voire plus, implique une distance de focale non négligeable et une taille de caisson importante, ce qui engendre un volume d'air par m² de lentilles important, rendant encore plus difficile la gestion de l'apparition de la condensation.

Différentes solutions ont été proposées pour résoudre ce problème de condensation.

L'une de ces solutions est décrite dans le document US 2011/0154683.

Ce document décrit un dispositif pour sécher l'intérieur d'un module solaire. Celui-ci est disposé à l'extérieur du caisson et est branché sur le caisson de sorte à permettre une circulation d'air entre l'environnement extérieur et l'intérieur du caisson.

Le dispositif comporte un ventilateur qui aspire l'air de l'extérieur, cet air traverse un absorbeur d'humidité, l'air ainsi asséché est introduit dans le module solaire. Pour régénérer l'absorbeur, celui-ci est traversé par de l'air préalablement chauffé, cet air étant rejeté vers l'environnement extérieur.

Cette solution présente l'inconvénient de consommer de l'énergie électrique et de nécessiter une maintenance du ventilateur, des moyens de chauffage et des électrovannes. Le document US 2013/0036909 décrit également un dispositif pour sécher l'intérieur d'un module solaire.

### EXPOSÉ DE L'INVENTION

C'est par conséquent un but de la présente invention d'offrir un module solaire d'un système photovoltaïque à concentration comportant un dispositif de régulation du niveau d'humidité de conception simple et robuste offrant une durée de vie importante, dont le fonctionnement ne consomme pas d'énergie électrique et offrant un nombre de pièces réduites.

Le but précédemment énoncé est atteint par un module solaire comportant un caisson et au moins une cellule photovoltaïque disposée dans le caisson, le fond supérieur du caisson étant formé au moins en partie par un système optique. Le caisson définissant un volume intérieur dans lequel se situe la cellule photovoltaïque, le module comportant également au moins un dispositif de régulation comprenant un matériau absorbant l'humidité disposé dans ou sur une paroi du caisson.

Un élément d'occultation protégeant le matériau absorbant l'humidité du rayonnement solaire concentré en cas de défocalisation du module solaire est disposé en regard du matériau absorbant l'humidité de sorte à ménager un passage entre l'élément occultant et le matériau absorbant l'humidité. L'air contenu dans le volume du caisson circule entre l'élément occultant et le matériau absorbant l'humidité.

La convection naturelle résulte de l'apparition d'un gradient de température entre les lentilles qui voient leur température s'abaisser pendant la nuit du fait du rayonnement vers le ciel nocturne et la partie inférieure du caisson qui ne rayonne pas vers le ciel.

L'air passant dans l'espace entre le matériau absorbant l'humidité et l'élément occultant est chargé de vapeur d'eau, la vapeur d'eau est alors absorbée par le matériau absorbant, et l'air ressortant est appauvri en vapeur d'eau.

Le dispositif est entièrement passif, il ne nécessite aucun apport d'énergie. Il ne dégrade donc pas le rendement énergétique global du système. Il est également de fait autonome et est très robuste. En outre, le matériau absorbant est protégé du flux concentré.

Il présente donc une durée de vie importante. Il ne demande peu ou pas de maintenance, celle-ci étant généralement complexe et coûteuse pour ce système dont l'implantation est souvent dans des zones isolées. Enfin, le coût de revient de ce dispositif est réduit.

Suivant la position du module solaire pendant la nuit, en position de sécurité du trackeur, il est préférable de positionner le dispositif comprenant le matériaux absorbant de telle sorte que la surface active du media soit dans le même plan que celui où se développe les mouvements de convection naturelle dus aux gradients de température intra caisson, par exemple le dispositif de régulation de l'humidité est disposé dans ou sur le fond inférieur du caisson.

Des moyens d'isolation thermique peuvent être avantageusement prévus entre le matériau absorbant l'humidité et le caisson et/ou entre le matériau absorbant l'humidité et l'élément occultant.

Avantageusement le matériau est hygro-régulant, ainsi il permet de maintenir un niveau d'humidité donné au sein du caisson.

Dans un mode préférentiel, le dispositif de gestion de l'humidité ne comporte pas de communication direct avec l'environnement extérieur à travers le caisson.

La présente invention a alors pour objet un module solaire à concentration comportant un caisson comprenant un fond supérieur formé par un système optique, et des parois, au moins une cellule photovoltaïque disposée dans le caisson, et au moins un dispositif de gestion de l'humidité, au moins une première paroi parmi lesdites parois comportant une partie principale contenue dans un plan, ledit dispositif de gestion de l'humidité comportant un logement défini entre ladite première paroi et des moyens d'occultation solidaires de ladite première paroi, un matériau absorbant l'humidité disposé dans ledit logement, au moins une partie du matériau absorbant l'humidité étant située d'un côté dudit plan contenant les moyens d'occultation.

Les moyens d'occultation sont disposés par rapport au matériau absorbant l'humidité de sorte à ménager un passage entre lesdits moyens d'occultation et le matériau absorbant l'humidité et de sorte que l'air contenu dans le volume du caisson circule dans le passage entre les moyens d'occultation et le matériau absorbant l'humidité et retourne dans le volume du caisson.

Dans un exemple de réalisation, le logement est défini par la partie principale de ladite première paroi, le matériau absorbant l'humidité étant entièrement situé du même côté du plan.

Dans un autre exemple de réalisation, la première paroi comporte une partie formée par une dépression, ladite dépression définissant avec les moyens d'occultation ledit logement, le matériau absorbant l'humidité étant contenu en partie dans ladite dépression. La dépression est avantageusement réalisée par emboutissage.

Dans un exemple de réalisation, le caisson peut comporter au moins une paroi latérale et une paroi inférieure opposée au fond supérieur, la première paroi étant formée par la paroi inférieure.

Dans un autre exemple de réalisation, le caisson comporte des parois latérales et une paroi inférieure opposée au fond supérieur, la première paroi étant formée par une desdites parois latérales.

Le dispositif de gestion de l'humidité peut comporter un capot portant les moyens d'occultation, les moyens d'occultation étant au moins formés par une plaque d'occultation.

De manière avantageuse, le capot comporte des parties de fixation de la plaque d'occultation à la première paroi, la plaque d'occultation étant pleine et lesdites parties de fixation étant ajourées de sorte à permettre l'établissement d'un flux d'air entre la plaque d'occultation et le matériau absorbant l'humidité.

De préférence, le capot comporte au moins une plaque d'occultation destinée à recevoir le flux solaire et une partie intérieure en regard du matériau de stockage, un espace étant ménagé entre ladite partie intérieure et ladite plaque d'occultation.

Un matériau d'isolation thermique différent de l'air peut être prévu entre la partie d'occultation et la partie intérieure.

La partie intérieure peut être avantageusement ajourée de sorte à permettre à l'air situé dans l'espace entre la partie intérieure et la plaque d'occultation d'entrer en contact avec le matériau absorbant l'humidité.

Dans un exemple avantageux, la partie intérieure est telle qu'elle exerce un effort sur le matériau de stockage en direction de la première paroi latérale.

Par exemple, la partie intérieure est sous forme de lames solidaires par une extrémité longitudinale à la plaque d'occultation et en appui contre le matériau absorbant l'humidité.

De manière très avantageuse, la plaque d'occultation, la partie intérieure et les parties de fixation sont d'un seul tenant.

Les parties de fixation peuvent également former des moyens de maintien du matériau absorbant l'humidité.

Un matériau d'isolation thermique peut être prévu entre le matériau absorbant l'humidité et les moyens de maintien et/ou entre le matériau absorbant l'humidité et la première paroi.

La distance entre la première paroi du logement et une face intérieure de la partie intérieure peut être égale à au moins 2 mm et la surface libre de passage d'air peut être égale à au moins égale à 10% du produit entre une largeur active du matériau absorbant l'humidité et la distance entre la partie principale de la première paroi du logement et une face intérieure du capot.

### BRÈVE DESCRIPTION DES DESSINS

La présente invention sera mieux comprise à l'aide de la description qui va suivre et des dessins en annexe sur lesquels :
- la figure 1 est une vue en coupe transversale schématique d'un exemple de réalisation d'un module unitaire d'un système à concentration équipé d'un dispositif de gestion de l'humidité selon un premier mode de réalisation de l'invention,
- la figure 2A est une vue en perspective du dispositif de gestion de l'humidité de la figure 1 sur la paroi latérale,
- la figure 2B est une vue en perspective du dispositif de gestion de l'humidité seul,
- la figure 2C est une vue en coupe longitudinale du dispositif de gestion de l'humidité des figures 2A et 2B dans une orientation différente,
- la figure 3A est une vue en coupe d'une partie d'autre exemple de réalisation d'un module selon le premier mode de réalisation de l'invention,
- les figures 3B et 3C sont des vues en perspective suivant deux points de vue du dispositif de gestion de l'humidité de la figure 4A,
- les figures 3D à 3F sont des vues en perspective de différents éléments du dispositif de gestion de l'humidité des figures 3A à 3C,
- la figure 4A est une vue en coupe d'une partie d'autre exemple de réalisation d'un module selon un deuxième mode de réalisation de l'invention,
- la figure 4B est une vue en perspective du dispositif de gestion de l'humidité de la figure 4A,
- la figure 5A est une vue en coupe d'une partie d'autre exemple de réalisation d'un module selon le deuxième mode de réalisation de l'invention,
- la figure 5B est une vue en perspective du dispositif de gestion de l'humidité de la figure 5A,
- la figure 6 est une représentation graphique de la différence de température entre la température de l'air contenu dans le module et la température de rosée en fonction du temps en jour de cet air pour un module avec dispositif de gestion de l'humidité selon l'invention et un module sans dispositif de gestion de l'humidité,
- la figure 7 est une représentation graphique de la variation du taux d'humidité relative en % de l'air contenu dans un module avec dispositif de gestion de l'humidité selon l'invention et la variation du taux d'humidité relative en % de l'air contenu dans un module sans dispositif de gestion de l'humidité, dans les mêmes conditions de fonctionnement.

### EXPOSÉ DÉTAILLÉ DE MODES DE RÉALISATION PARTICULIERS

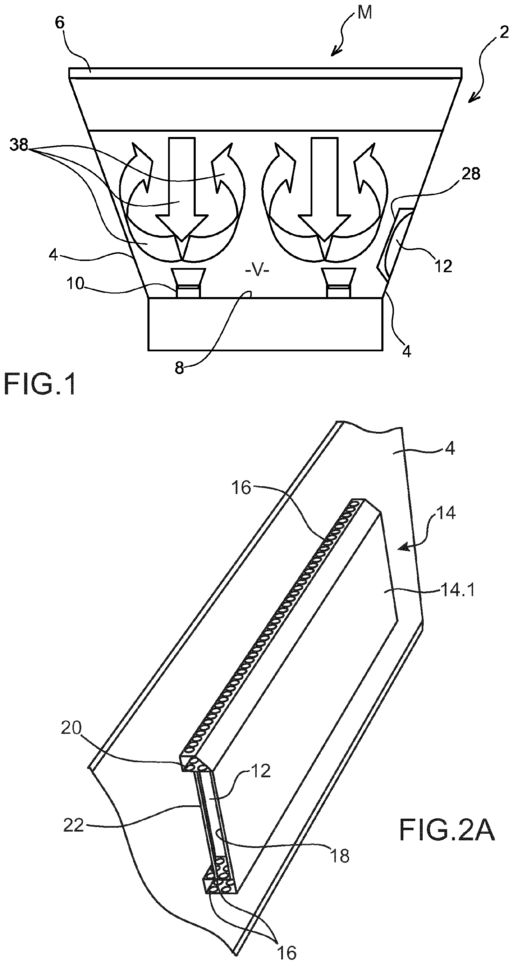

Sur la figure 1, on peut voir une représentation schématique d'un exemple de module M unitaire selon l'invention d'un système à concentration à lentille de Fresnel comportant un caisson 2 composé d'une paroi latérale 4, d'un fond supérieur 6 et d'un fond inférieur 8.

Le fond supérieur 6 est formé par un optique primaire comportant une ou plusieurs lentilles de Fresnel. Le fond inférieur 8 supporte des cellules photovoltaïques 10 par exemple du type triples jonctions. Chaque lentille focalise sur une cellule photovoltaïque 10. De préférence, le ou les cellules photovoltaïques 10 sont munies de dissipateurs de chaleur orientés vers l'extérieur du fond inférieur 8.

La paroi latérale 4, le fond supérieur 6 et le fond inférieur 8 délimitent un volume V contenant de l'air dont on souhaite contrôler le taux d'humidité.

Le module M comporte également un dispositif de gestion de l'humidité à l'intérieur du caisson. Le dispositif est monté sur la paroi latérale 4 du caisson 2 à l'intérieur du caisson 2.

Le dispositif de gestion de l'humidité, désigné par la suite dispositif de gestion, comporte un matériau absorbant l'humidité 12 qui est en contact avec l'air contenu dans le volume V.

Le matériau absorbant est par exemple disposé à l'intérieur d'un contenant souple, désigné « sachet » qui sera décrit en détail par la suite

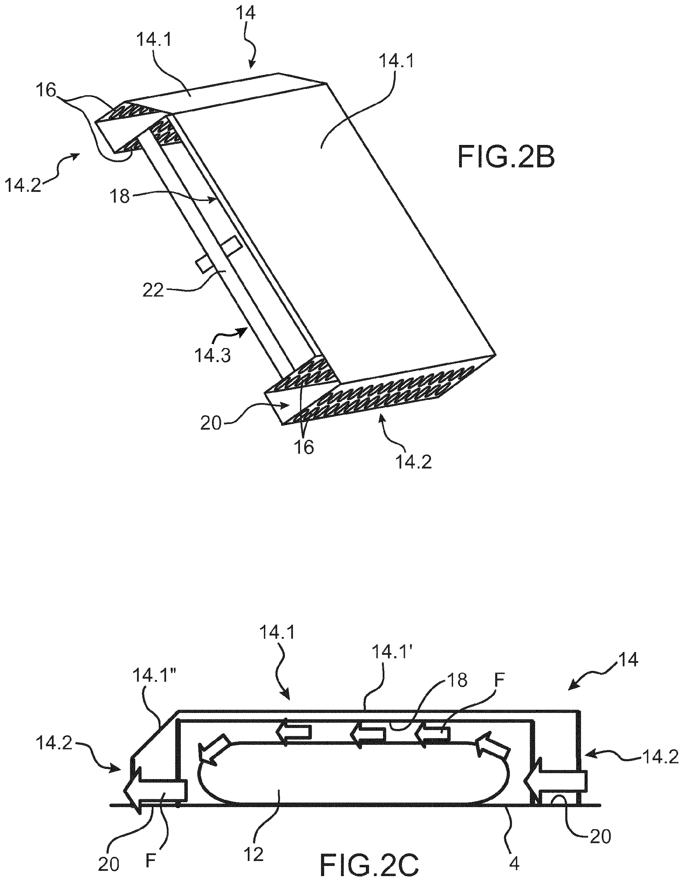

Sur les figures 2A, 2B et 2C, on peut voir un exemple de réalisation du dispositif de gestion.

Le dispositif de gestion comporte un capot 14 fixé sur la paroi latérale 4 du caisson et délimitant un logement avec la paroi latérale 4 du caisson, dans lequel est reçu le matériau absorbant.

Le capot 14 comporte une partie d'occultation 14.1 sensiblement parallèle au caisson et des parties de fixation 14.2 destinées à la fixation du capot 14 sur le caisson.

Les dimensions du capot 14 sont telles qu'une distance non nulle est ménagée entre le matériau absorbant 12 et la partie d'occultation 14.1. La partie d'occultation 14.1 est pleine et est destinée à protéger le matériau absorbant des rayons solaires concentrés, par exemple en cas de défocalisation, afin d'éviter de détériorer ou d'inhiber le fonctionnement du matériau absorbant par brûlure ou par échauffement.

Dans l'exemple représenté, la partie d'occultation 14.1 présente une partie de grande surface 14.1' sensiblement parallèle à la paroi latérale et une partie inclinée 14.1" prolongeant la protection du matériau. Cette partie inclinée offre la même protection qu'une partie plane s'étendant sur la même longueur tout en présentant un encombrement réduit.

Dans l'exemple représenté, les parties de fixation sont situées au niveau des extrémités longitudinales inférieure et supérieure du capot, en considérant le sens de circulation du flux d'air symbolisé par la flèche F.

Les parties de fixation 14.2, outre leur fonction de fixation du capot sur la paroi latérale, sont réalisées de sorte à permettre l'établissement d'un flux d'air entre le capot et le matériau absorbant; ce flux d'air est symbolisé par les flèches F et circule de la partie inférieure du caisson de gestion vers sa partie supérieure.

Le flux d'air est provoqué par la convection naturelle qui est schématisée par les flèches 38 sur la figure 1.

Les parties de fixation 14.2 sont alors ajourées pour permettre l'écoulement de l'air. Dans l'exemple représenté, des trous 16 sont réalisés dans les parties de fixation. Il sera compris que les parties de fixation pourraient être réalisées différemment pour assurer la liaison entre la partie d'occultation et le caisson et permettre le passage de l'air. Elles pourraient en variante comporter des fenêtres ou être formées par des râteliers. Dans l'exemple représenté, le nombre de trous au niveau de la partie de fixation de sortie est inférieur à celui au niveau de la partie de fixation d'entrée, mais ceci n'est en aucun cas limitatif. Le nombre de trous et/ou la section de passage de ces trous pourraient être identiques ou alors supérieurs sans sortir du cadre de la présente invention.

Dans un mode préférentiel, le dispositif de gestion de l'humidité ne comporte pas de communication avec l'environnement extérieur, plus particulièrement la zone de la paroi latérale 4 définissant le logement du matériau absorbant ne comporte pas d'orifice permettant un transfert d'air entre l'extérieur et l'intérieur du dispositif de gestion d'humidité. Les échanges d'air avec le dispositif de gestion de l'humidité, plus particulièrement avec l'espace défini entre la paroi latérale et le capot, s'effectue alors uniquement avec l'intérieur du caisson par convection naturelle comme cela sera décrit par la suite.

De préférence, les surfaces directement en regard du matériau absorbant présentent des zones ajourées représentant au moins 30% des surfaces totales en regard. Comme nous le verrons par la suite, des éléments peuvent être en contact avec la surface du matériau absorbant opposée à celle en contact avec le caisson, ces éléments présentent avantageusement des zones ajourés et sont des parties en regard du matériau absorbant.

De manière avantageuse, la partie d'occultation et les parties de fixation sont réalisées d'un seul tenant par pliage d'une tôle.

De manière particulièrement avantageuse et comme cela est représenté, le capot est réalisé de sorte à assurer une isolation thermique suffisante par rapport à l'échauffement du capot imposé par le flux solaire. Le capot présente alors une double paroi au moins au niveau de la partie d'occultation. En particulier, le capot comporte une partie intérieure 18 parallèle et située à distance de la partie d'occultation. Une couche d'air présente entre la partie d'occultation 14.1 et la partie intérieure 18 assure une isolation thermique de la partie intérieure 18. Ainsi si le matériau venait en contact avec la partie intérieure, il resterait protégé d'une température trop élevée. Un autre matériau d'isolation thermique que l'air peut être prévu entre la partie d'occultation 14.1 et la partie intérieure 18. Le matériau d'isolation thermique peut être choisi par exemple parmi la famille des mousses de polymère ou la famille des laines minérales.

De préférence, la distance minimale entre la partie d'occultation 14.1 et la partie intérieure 18 afin d'éviter la transmission de flux de chaleur au matériau absorbant est d'au moins 1 mm.

Une surface libre de passage d'air humide est définie comme étant la section où l'air à traiter peut librement passer au niveau du matériau absorbant. De préférence, la surface libre de passage d'air est au moins égale à 1/10^{éme} du produit de la largeur active du matériau absorbant par la distance entre la paroi du caisson et le partie d'occultation 14.1 ou la partie intérieure 18, lorsqu'une telle partie est mise en oeuvre, pendant toute la durée de vie du produit en tenant compte de la variation de volume du matériau absorbant. Le matériau absorbant peut être sous forme de granules, poreux ou insufflé.

La partie intérieure 18 peut servir de moyen de maintien mécanique du matériau absorbant.

Un ou des matériaux d'isolation thermique (non représentés) peuvent également être avantageusement prévus entre le matériau absorbant et la paroi du caisson afin de protéger le matériau.

Du fait de la réalisation d'un seul tenant, les parties de fixation 14.2 sont également doublées, la fixation du capot sur le caisson est alors réalisée au niveau de parties de connexion 20 entre les deux parties de fixation 14.2. De manière préférée, les parties de connexion 20 sont pleines, ce qui améliore la dissipation du flux dans la paroi 4 du caisson et permet donc de préserver encore davantage le matériau absorbant du flux thermique. Par ailleurs, la fixation du capot à la paroi 4 sera facilitée. La fixation peut être réalisée par exemple par pointage, collage, rivetage, soudage ou encliquetage. Un capot dans lequel par exemple la partie intérieure 18 serait réalisée séparément puis fixées à la partie d'occultation ne sort pas du cadre de la présente invention.

Dans l'exemple représenté, le capot présente des bords latéraux 14.3 ouverts. De manière avantageuse, des moyens de retenue latérale du matériau absorbant sont prévus. Par exemple, il s'agit de barres 22 fixées aux parties de fixation 14.2.

Il peut être prévu de réaliser ces barres de retenue latérale d'un seul tenant avec le capot. De préférence, les moyens de retenue latérale sont tels qu'ils offrent une grande section de passage à l'air pour que celui-ci circule entre le caisson et le zone entre le capot et le matériau absorbant.

En variante, il pourrait être envisagé que le capot des figures 2A à 2C soient orientés de sorte que les parties de fixation 14.2 soient situées latéralement.

En outre, le capot pourrait être réalisé par emboutissage puis perçage ou estampage pour réaliser les trous de circulation. Dans le cas d'un capot à double paroi, il peut être envisagé de réaliser deux formes correspondantes par emboutissage présentant des profondeurs différentes et de les emboîter l'une dans l'autre.

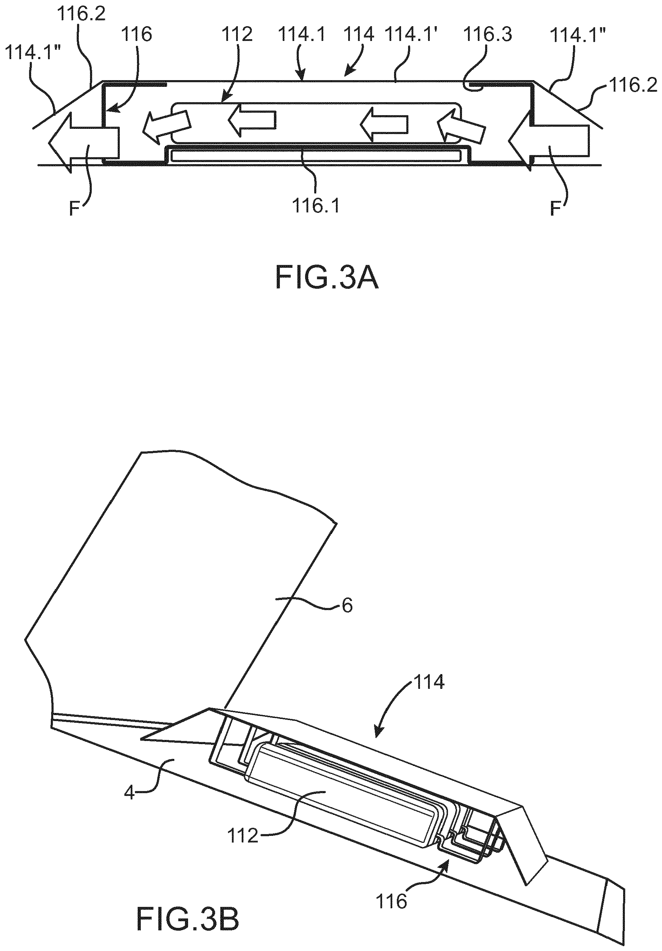

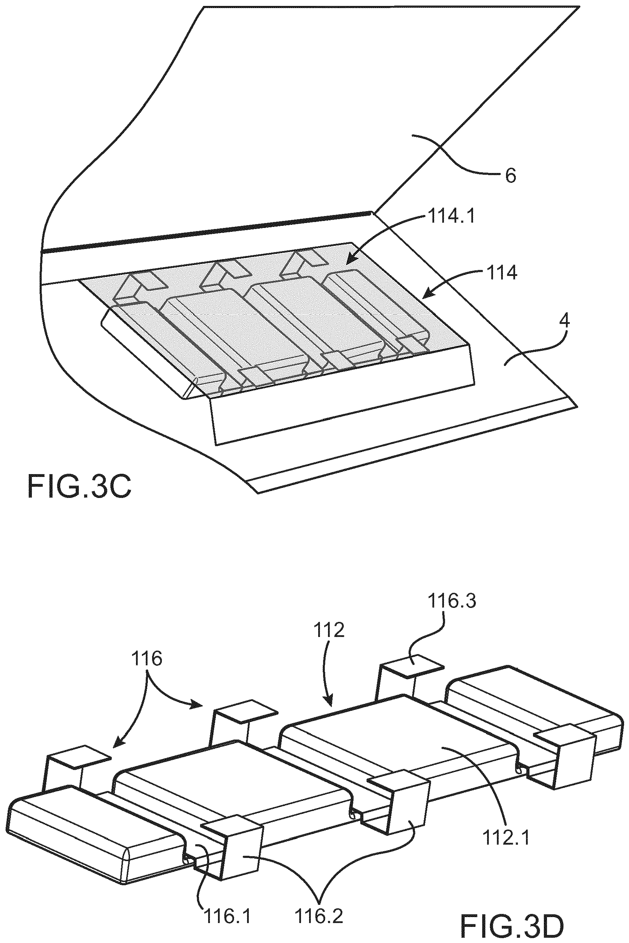

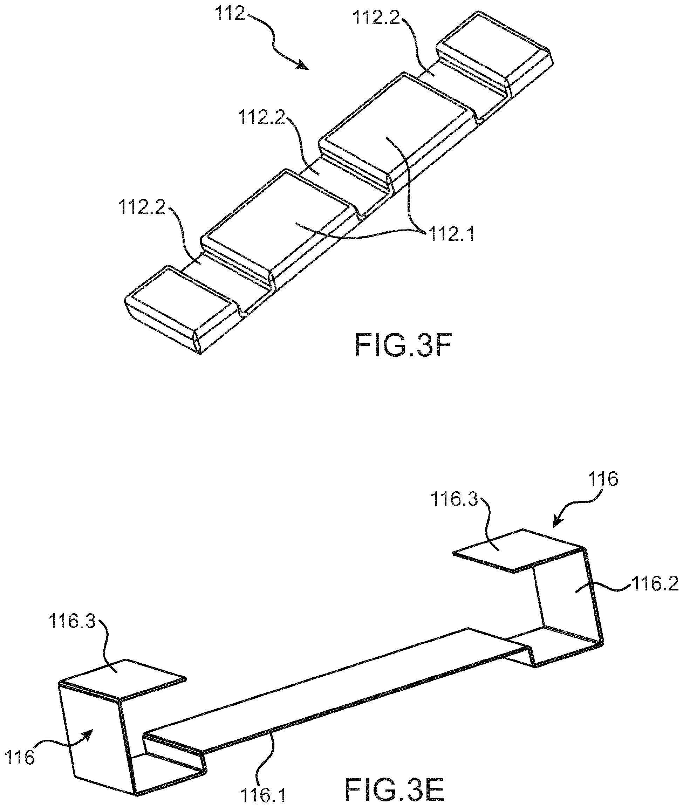

Sur les figures 3A à 3E, on peut voir un autre exemple de réalisation d'un dispositif de gestion selon le premier mode de réalisation dans lequel le matériau de gestion est disposé sur une face interne du caisson.

Dans cet exemple de réalisation, le dispositif de gestion comporte un capot 114, un matériau absorbant 112 et des moyens de maintien du matériau absorbant sur le caisson.

Dans cet exemple, le capot 114 comporte une seule paroi. Il comprend une partie d'occultation 114.1 formée par une partie 114.1' sensiblement parallèle à la paroi du caisson et des parties d'extrémité supérieure et inférieures inclinées 114.1". Les parties d'extrémité 114.1" pourraient comporter des fenêtres pour la circulation du flux et/ou de disposer la partie d'occultation de sorte qu'un jeu existe entre les extrémités libres des parties inclinées 114.1" et la paroi du caisson, la fenêtre et/ou le jeu étant tels que le matériau absorbant reste protégé du flux solaire.

En effet, la mise en oeuvre de moyens de maintien du matériau absorbant évite le contact entre la partie d'occultation et le matériau absorbant. Dans l'exemple représenté, les moyens de maintien 116 comportent une portion 116.1 destinée à être en contact avec le matériau et à le maintenir et deux portions 116.2 repliées perpendiculairement par rapport à la portion 116.1 destinées à maintenir le capot 114 à distance du matériau, assurant ainsi la protection du matériau en cas de fonctionnement non nominal du module. La portion 116.1 assure également la fixation des moyens de maintien 116 sur la paroi 4, par exemple par soudage, pointage ou rivetage des extrémités longitudinales 116.

De manière avantageuse, les moyens de maintien 116 assurent également la fixation de la partie d'occultation sur le caisson, pour cela chacune des portions 116.2 comporte une extrémité libre repliée 116.3 et fixée à la face intérieure de la partie d'occultation 114.1 par exemple par soudage, collage... En variante, on pourrait envisager que la partie d'occultation soit directement fixée sur le caisson, les parties repliées 116.2 n'assurant que le maintien d'un jeu entre la partie d'occultation et le matériau absorbant.

Les moyens de maintien 116 sont avantageusement réalisés par pliage de bande de tôle.

Comme on peut le voir sur la figure 3B, plusieurs moyens de maintien sont mis en oeuvre. Les moyens de maintien sont disposés à distance les uns des autres, de sorte à ménager un passage libre pour assurer le contact entre le flux d'air et le matériau absorbant.

Dans l'exemple représenté, le matériau absorbant 112 est conformé de sorte à présenter des compartiments 112.1 séparés par des zones sans matériau absorbant 112.2 contre lesquelles les portions de maintien viennent en contact. Cette forme du matériau absorbant n'est en aucun cas limitative, le matériau absorbant pourrait présenter une épaisseur sensiblement constante, les portions d'appui 116.1 étant alors conformées en conséquence. Par exemple, les portions d'appui pourraient présenter une forme incurvée en regard du matériau absorbant. Cette variante permet d'utiliser un matériau absorbant non compartimenté.

De préférence, la surface des portions de maintien en contact avec le matériau est réduite de sorte à réduire les échanges thermiques entre la partie d'occultation et le matériau et éviter ainsi la détérioration du matériau.

De manière avantageuse, un ou des matériaux d'isolation thermique peuvent être prévus entre le matériau absorbant et les portions de maintien 116.1. De manière avantageuse, un ou des matériaux d'isolation thermique peuvent également être prévus entre le matériau absorbant et le caisson.

Cet exemple de réalisation ne requiert pas de moyens de retenue latérale.

En variante, les portions de maintien pourraient être orientés perpendiculairement au flux d'air ou suivant un autre angle.

En variante, on pourrait prévoir que le matériau absorbant ne soit pas compartimenté, les moyens de maintien seraient en regard de matériau absorbant. Dans cette variante, on pourrait alors envisager que les portions de maintien 116.1 comportent des trous ou des fenêtres dans les portions repliées 116.2.

De préférence, la hauteur du dispositif de gestion est telle qu'il n'intercepte pas le flux solaire concentré depuis le système optique, la lentille de Fresnel par exemple, jusqu'à la cellule qui réalise la transformation photoélectrique.

Comme pour le dispositif des figures 2A à 2C, dans un mode préférentiel, le dispositif de gestion de l'humidité des figures 3A à 3F ne comporte pas de communication avec l'environnement extérieur.

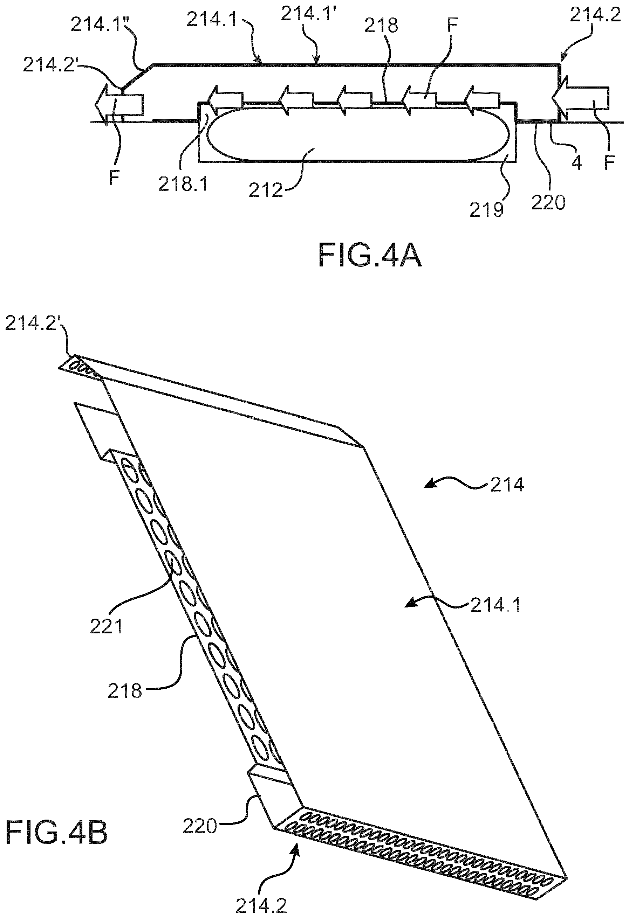

Sur les figures 4A et 4B, on peut voir un exemple de réalisation d'un dispositif de gestion selon un deuxième mode de réalisation. Ce deuxième mode de réalisation diffère du premier mode en ce que le matériau absorbant est disposé en partie dans le volume du caisson et en partie dans un logement formé dans une paroi du caisson. Ce mode de réalisation présente l'avantage de reporter une partie de l'encombrement du dispositif à l'extérieur du volume intérieur du caisson.

De préférence, au moins 10 % du matériau absorbant sont contenus à l'intérieur du caisson et donc au plus 90 % du matériau absorbant sont contenus dans le logement formé dans la paroi.

Le dispositif de gestion comporte un capot 214, un matériau absorbant 212 et un réceptacle 219 réalisé par emboutissage dans une paroi du caisson, la paroi latérale 4 dans l'exemple représenté. Le matériau absorbant est reçu dans un logement délimité par le réceptacle et le capot 214. Par exemple, l'embouti a une profondeur comprise entre 20 mm à 25mm

Le capot 214 présente une forme proche de celle de l'exemple des figures 2A à 2C.

Le capot comporte une partie d'occultation 214.1 sensiblement parallèle au caisson et une partie de fixation 214.2 destinées à la fixation du capot sur le caisson.

Dans cet exemple, la partie de fixation 214.2 est située à l'extrémité du capot 214 par laquelle le flux entre.

Les dimensions du capot sont telles qu'une distance d non nulle est ménagée entre le matériau absorbant et la partie d'occultation. La partie d'occultation 214.1 est pleine et est destinée à protéger le matériau absorbant des rayons solaires concentrés.

Dans l'exemple représenté, la partie d'occultation 214.1 présente une partie de grande surface 214.1' sensiblement parallèle à la paroi latérale et une partie inclinée 214.1" prolongeant la protection du matériau. Dans l'exemple représenté, la partie inclinée 214.1" se prolonge par une partie 214.2' perpendiculaire à la paroi latérale dans laquelle des trous pour l'évacuation du flux sont prévus. La partie de fixation 214.2, outre sa fonction de fixation du capot sur la paroi latérale, est réalisée de sorte à permettre l'établissement d'un flux d'air entre le capot et le matériau absorbant, ce flux d'air étant symbolisé par les flèches F et circule de la partie inférieure du dispositif de gestion vers sa partie supérieure. En variante, la partie 214.2' peut être omise si les parties d'occultation 214.1' et/ou 214.1" sont suffisants pour protéger efficacement le matériau absorbant des flux issus de la défocalisation.

Le flux d'air est provoqué par la convection naturelle qui est schématisée par les flèches 38 sur la figure 1.

La partie de fixation 214.2 est alors ajourée pour permettre l'écoulement de l'air. Dans l'exemple représenté, des trous 216 sont réalisés dans les parties de fixation. Il sera compris que la partie de fixation pourrait être réalisée autrement pour assurer la liaison entre la partie d'occultation et le caisson et permettre le passage de l'air. Elle pourrait en variante comporter des fenêtres ou être formée par des râteliers. Dans l'exemple représenté, le nombre de trous au niveau de la partie de fixation de sortie est inférieur à celui au niveau de la partie de fixation d'entrée, mais ceci n'est aucun cas limitatif. Le nombre de trous et/ou la section de passage de ces trous pourraient être identiques ou alors supérieurs sans sortir du cadre de la présente invention.

De manière avantageuse la partie d'occultation 214.1 et les parties de fixation 214.2 sont réalisées d'un seul tenant par pliage d'un tôle.

De manière également avantageuse et comme cela est représenté, le capot est réalisé de sorte à présenter une double paroi. En particulier, le capot comporte une partie intérieure 218 à distance de la partie d'occultation. Une couche d'air présente entre la partie d'occultation 214.1 et la partie intérieure 218 représente la section de passage à proximité de la surface active du matériau absorbant, de l'air situé dans le caisson à hygroréguler. Elle forme également une isolation thermique.

Dans l'exemple représenté, la partie intérieure 218 comporte une cavité 218.1 délimitant avec le réceptacle embouti dans le caisson le logement du matériau absorbant, le matériau absorbant étant maintenu entre le fond du réceptacle et le fond de la cavité.

De manière préférée, la partie intérieure 218 comporte des ouvertures 221, par exemple des perçages, permettant à l'air circulant entre la partie d'occultation et la partie intérieure d'entrée en contact avec le matériau absorbant. En variante, la partie intérieure pourrait être formée par des bandes séparées les unes des autres de sorte que du matériau absorbant soit accessible pour l'air ou toute autre structure.

Un ou des matériaux d'isolation thermique peuvent également être avantageusement prévus entre le matériau absorbant et la paroi du caisson afin de protéger le matériau.

Du fait de la réalisation préférentielle d'un seul tenant, la partie de fixation est également doublée, la fixation du capot sur le caisson est alors réalisée au niveau de la partie de connexion 220 entre les deux parties de fixation 214.2. De préférence, le capot est fixé sur la paroi latérale aux deux extrémités longitudinales de la partie intérieure de part et d'autre de réceptacle 219. De manière préférée, la partie de connexion 220 est pleine. La fixation peut être réalisée par exemple par pointage, collage, rivetage, soudage ou encliquetage.

En variante, on pourrait prévoir une structure fermée, dans laquelle la partie intérieure 218 serait reliée à la partie 214.2' par une partie de connexion 220.

De préférence, la distance entre la partie d'occultation 214.1 et la partie intérieure 218 est au moins de 2 mm.

Dans ce deuxième mode de réalisation, la surface libre de passage d'air est de préférence au moins égale à 1/10^{ème} du produit entre la largeur active du matériau absorbant et la distance entre le fond du réceptacle et la partie d'occultation 214.21 ou la partie intérieure 218 lorsqu'une telle partie est mise en oeuvre, pendant la durée de vie du produit en tenant compte de la variation de volume du matériau absorbant. Le matériau absorbant peut être sous forme granulaire, être poreux ou insufflé.

Il sera compris qu'un capot à une seule paroi formant la partie d'occultation 214.1 ne sort pas du cadre de la présente invention.

Comme pour le dispositif des figures 2A à 2C, dans un mode préférentiel, le dispositif de gestion de l'humidité des figures 4A et 4B ne comporte pas de communication avec l'environnement extérieur.

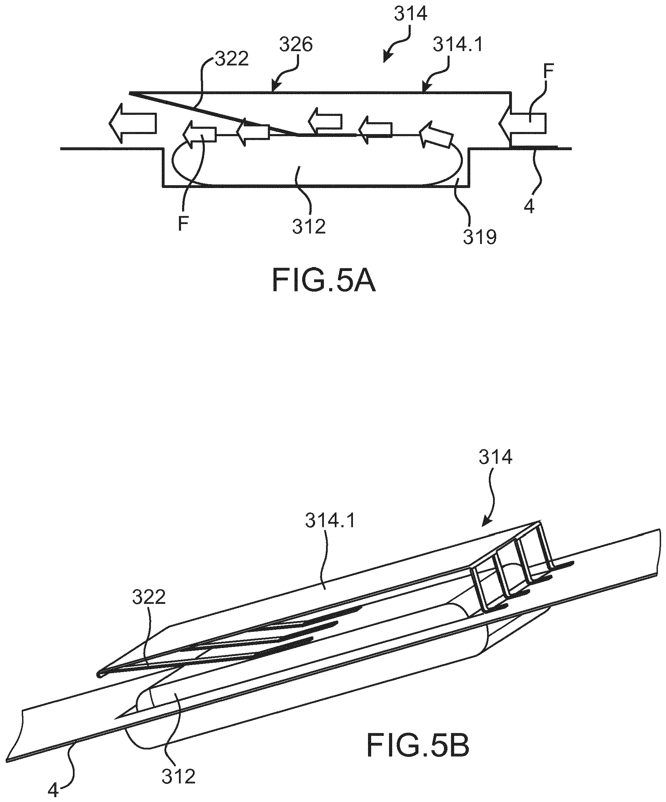

Sur les figures 5A et 5B, on peut voir un autre exemple de réalisation d'un dispositif de gestion selon le deuxième mode de réalisation. Le dispositif de gestion comporte un capot 314, un matériau absorbant 312 et un logement 318 réalisé par emboutissage dans une paroi du caisson, la paroi est latérale dans l'exemple représenté.

Le capot 314 comporte une partie d'occultation 314.1 et une partie de fixation 314.2 à la paroi latérale.

Dans l'exemple représenté, la partie d'occultation 314.1 présente une forme plane sensiblement parallèle à la paroi. La partie de fixation a un profil en L, dont la base est fixée à la paroi et l'extrémité libre de la partie verticale et reliée à la partie d'occultation. De manière préférée, plusieurs éléments en L sont disposés transversalement à distance l'un de l'autre ménageant entre eux un passage pour le flux d'air. Une seule bande en L s'étendant sur une grande partie de la largeur de la partie d'occultation avec des trous ou fenêtres ne sort pas du cadre de la présente invention

De manière avantageuse, des moyens de maintien 320 du matériau absorbant sont prévus. Dans l'exemple, ces moyens 320 sont formés par au moins une lame 322 solidaire de la partie d'occultation et disposée entre la partie d'occultation et le matériau absorbant. La lame est repliée de sorte à appliquer un effort sur le matériau vers le fond du logement 319. De manière préférée et comme cela est représenté, les moyens de maintien comportent plusieurs lames réparties sur la largeur du capot à distance les unes des autres ménageant entre elles un passage pour le flux d'air. Dans le cas où une seule lame est mise en oeuvre, celle-ci est de préférence ajourée.

De manière très avantageuse le ou les lames 322 sont réalisées d'un seul tenant avec la partie d'occultation et avec les éléments de fixation. Le capot est avantageusement réalisé par pliage.

Cette lame ou ces lames sont pliées de sorte à offrir un effet ressort qui permet d'assurer le maintien permanent du matériau malgré les variations de volume du matériau absorbant. De préférence les lames sont recouvertes au niveau des zones d'appui en contact avec le matériau absorbant d'un matériau d'isolation thermique.

Les parois latérales du logement embouti assurent un maintien latéral du matériau, évitant le recours à des moyens de retenue latérale supplémentaires.

Comme pour le dispositif des figures 2A à 2C, dans un mode préférentiel, le dispositif de gestion de l'humidité des figures 5A et 5B ne comporte pas de communication avec l'environnement extérieur.

Il sera compris que les différents exemples de réalisation peuvent être combinés. Par exemple, on peut envisager de mettre en oeuvre les moyens de maintien 116 des figures 3A à 3F dans le dispositif de gestion des figures 2A à 2C ou celui des figures 4A et 4B.

Les lames de maintien des figures 5A et 5B peuvent être mis en oeuvre dans le dispositif des figures 2A et 2B.

Le capot et les moyens de maintien sont avantageusement réalisés dans un matériau bon conducteur thermique par exemple en aluminium ou en alliage d'aluminium. L'acier ou des alliages peut également convenir.

Nous allons maintenant décrire le matériau absorbant. Par exemple, celui-ci est un gel de silice, un tamis moléculaire en zéolite, de l'argile type Montmorillonite, de l'alumine activée, du sulfate de calcium

De manière très avantageuse, le matériau absorbant est un matériau absorbant et hygro-régulant, qui a pour effet de maintenir un certain niveau d'humidité.

De tels matériaux possèdent des capacités d'absorption et des réversibilités fonctionnelles variables. On entend par « réversibilité » la capacité du composé chimique à absorber et désorber de la vapeur d'eau dans des conditions de température données.

Par exemple, le taux d'humidité maximal pour éviter l'apparition de condensation a été évalué à environ 40%. Une hygro-régulation autour de cette valeur et des amplitudes de variation comprises entre 30% et 50% permettent de maintenir un tel taux d'humidité. Par exemple, le chlorure de calcium possède un pouvoir hygro-régulant entre 40% et 50% d'humidité relative (à une température de 20°C).

Le matériau se présente par exemple sous forme de poudre, de granulés, de billes ou gel.

Le matériau absorbant peut être disposé dans un contenant. De préférence celui-ci est souple et est tel qu'il est apte à accommoder les variations de volume du matériau. Par exemple, le contenant est un sachet à soufflet 32 tel que représenté sur la figure 5. En outre, le sachet comporte par exemple une face en un matériau étanche à l'eau, par exemple un film plastique et une face en un matériau perméable à la vapeur d'eau, type membrane respirante. La membrane perméable forme la surface active du sachet et est destinée à être orientée du côté de l'intérieur du caisson.

Le dispositif de gestion selon l'invention permet de mettre en oeuvre des matériaux de nature différente. Il peut donc s'adapter à tous les composés déshydratants et absorbeurs d'humidité disponibles.

La quantité de matériau absorbant est choisie en fonction du temps estimé de fonctionnement et des conditions hygrométriques du site d'implantation. Par exemple, en climat continental, pour un volume de caisson d'environ 400 litres une masse d'environ 1kg de chlorure de calcium est requise pour un fonctionnement d'une durée de 15 ans

Le fonctionnement du dispositif de gestion va maintenant être décrit à l'aide de la figure 1.

Sur la figure 1, les mouvements d'air par convection naturelle sont représentés par les flèches 38.

La représentation choisie est celle du moment de la fin de la nuit et début de matin, le moment où la température du fond supérieur 6 du caisson formé de lentilles est la plus froide et risque de descendre en dessous la température de rosée. Le refroidissement local qui s'opère au voisinage de la microstructure dentelée des lentilles de Fresnel au niveau de l'optique primaire provient des déperditions thermiques dues au rayonnement thermique vers le ciel pendant la nuit. De plus, la faible absorptivité et la forte transmittivité optiques des lentilles empêchent le flux solaire incident de réchauffer l'air localement.

En revanche, le fond inférieur 8 comportant les cellules photovoltaïques subit un réchauffement local dû à l'action des dissipateurs et de la tôle de fond qui sont soumis aux mouvements d'air locaux à température ambiante.

Il apparaît donc un gradient thermique dans le volume intérieur du module qui induit des transferts de masse d'air qui pilotent des mécanismes de convection d'air. De plus, l'air humide est plus léger que l'air sec.

Des écoulements d'air symbolisés par les flèches 38 ont donc lieu à proximité du boîtier contenant le matériau absorbant.

Il y a donc un écoulement d'air humide du bas vers le haut entre la partie d'occultation et le matériau absorbant 12. La vapeur d'eau contenue dans l'air est absorbée par le matériau absorbant à travers la membrane perméable. L'air qui ressort est alors asséché.

Le matériau absorbant, en absorbant la vapeur d'eau augmente de volume, l'enveloppe se déplie pour s'adapter au volume du matériau absorbant.

Dans le cas d'un matériau absorbant hygro-régulant, au cours de la journée lorsque la température dans le boîtier augmente suffisamment, le matériau se régénère en relarguant la vapeur d'eau dans le caisson et assurant le maintien d'un niveau d'humidité sensiblement constant dans le caisson.

Le caisson peut également comporter un évent obturé par une membrane dite respirante, laissant passer l'air et la vapeur d'eau mais pas l'eau liquide.

Un module peut comporter un ou plusieurs dispositifs de gestion d'humidité en fonction du volume d'air du module.

Dans l'exemple représenté sur la figure 1, le caisson comporte quatre parois latérales planes. Un caisson ayant une paroi latérale de forme tronconique ne sort pas du cadre de la présente invention.

Le dispositif de gestion de l'humidité est entièrement passif, ainsi le rendement énergétique global du système n'est pas dégradé. En outre, il est autonome, offre une grande fiabilité dans le temps et offre une durée de vie longue avec peu ou pas d'entretien.

En outre, celui-ci met en oeuvre peu de pièces et leur assemblage est relativement simple. En particulier dans le cas d'une solution d'un seul tenant, seul le capot est fabriqué à partir d'une tôle par découpage, pliage et perforation, puis fixé sur la paroi de manière simple, la paroi ayant été préalablement emboutie ou non.

Le coût de revient est donc réduit.

En outre, le dispositif est relativement compact et peut être aisément intégré dans un module solaire existant. En outre, il n'interfère pas avec le flux solaire en fonctionnement nominal, ne réduisant ainsi pas le rendement du module.

La présente invention permet de réaliser à la fois :
- la protection du matériau absorbant des flux solaires concentrés issus d'un fonctionnement non nominal du système optique, par exemple du fait d'un dépointage du flux solaire concentré dû à mauvais fonctionnement du tracker,
- la non transmission de flux thermique entre la partie d'occultation du flux solaire (issue d'un fonctionnement non conventionnel du système optique) et le matériau absorbant,
- la circulation d'air à proximité du matériau absorbant, celui-ci restant accessible aux mouvements convectifs à l'intérieur du caisson,

En outre, le maintien mécanique du matériau absorbant peut être assuré de telle manière que l'intégrité du matériau absorbant n'est pas compromise, notamment dans le cas de mise en oeuvre de sachet, il n'y a pas de risque de déchirure, ni de compression, en particulier compte tenu des variations du volume du matériau absorbant dues à l'absorption d'humidité. En outre, les contacts entre le matériau absorbant et les moyens de maintien peuvent être minimisés pour réduire la transmission de chaleur au matériau absorbant.

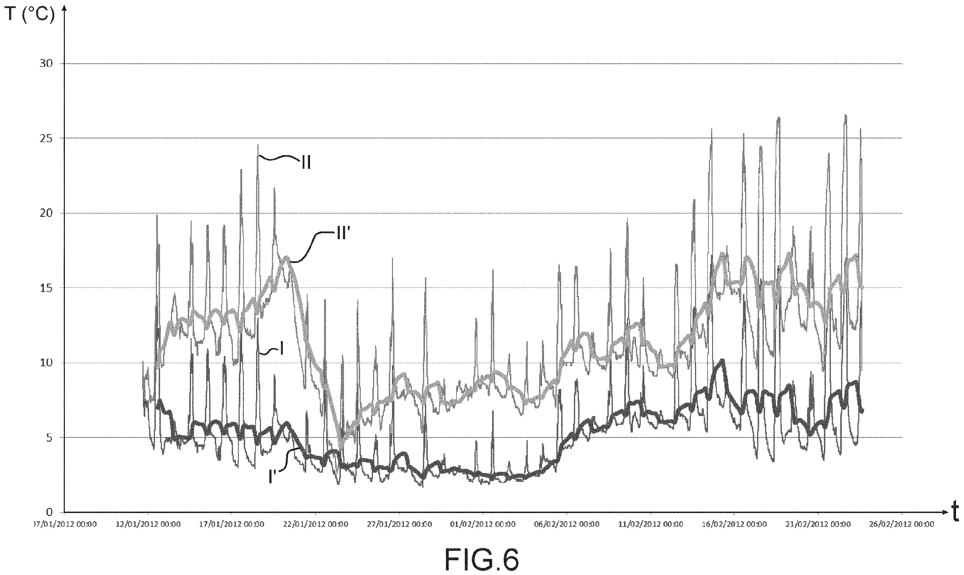

Sur la figure 6, on peut voir représentées par les courbes I et II les différences de température ΔT en °C en fonction du temps en jours entre l'air du caisson et la température de rosée de ce même air dans le cas d'un module sans dispositif de gestion selon l'invention et d'un module avec dispositif de gestion selon l'invention respectivement. Les courbes l'et II' représentent la moyenne mobile des courbes I et II respectivement.

Plus la différence de température est importante, plus le risque de voir apparaître de la condensation est réduit, sachant que la température de la lentille est au petit matin quelques degrés inférieure à celle de l'air du caisson, du fait du rayonnement de la lentille vers le ciel, par exemple de 2°C à 5°C par ciel clair. Ainsi au vu des différences de température représentées par la courbe II, si on considère une température de lentilles de 2 °C à 5°C, par rapport à celle de l'air du caisson, celle-ci reste encore très supérieure à la température de rosée.

On constate donc l'efficacité du dispositif de gestion selon l'invention.

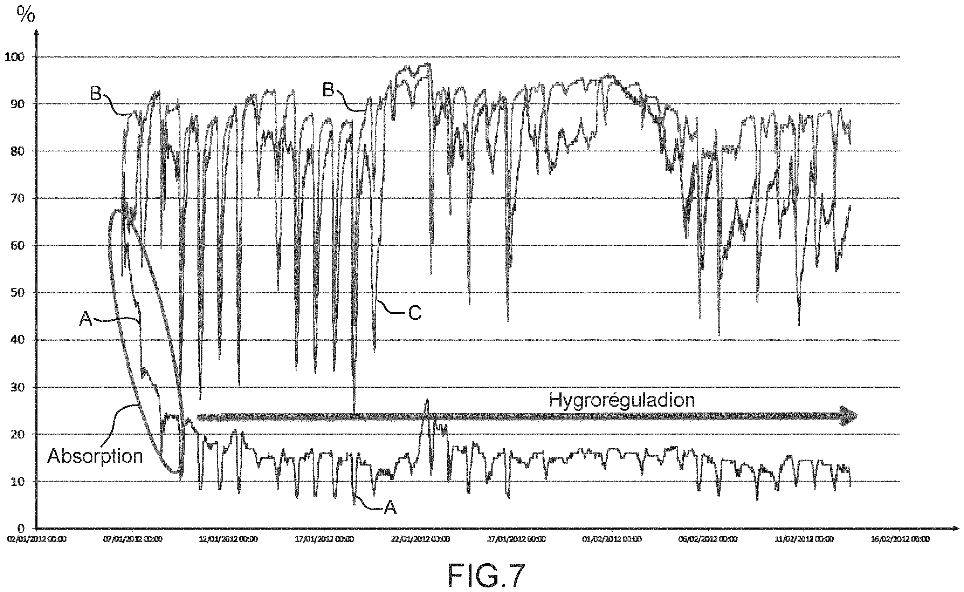

Sur la figure 7, on peut voir une représentation graphique de la variation du taux d'humidité relative en % de l'air contenu dans un module avec dispositif de gestion de l'humidité selon l'invention (courbe A) et la variation du taux d'humidité relative en % de l'air contenu dans un module sans dispositif de gestion de l'humidité (courbe B). La courbe C représente le taux d'humidité de l'environnement extérieur.

Sur la courbe A, on observe une première étape d'absorption de l'humidité jusqu'à la fourchette de régulation, on observe ensuite une deuxième étape d'hygro-régulation de l'intérieur du caisson par rapport aux différents apports de vapeur d'eau, par exemple diffusion à travers les joints, étanchéité mal réalisée, membrane respirante dans certains cas... sur la courbe B, on observe que le taux d'humidité dans le caisson suit sensiblement celui à l'extérieur du caisson.

Le module solaire selon l'invention peut être mis en oeuvre dans tous les systèmes solaires à concentration et est particulièrement adapté à la mise en oeuvre dans les systèmes solaires à concentration à lentilles de Fresnel.

## Revendications

1. Module solaire à concentration comportant un caisson (2) comprenant un fond supérieur (6) formé par un système optique, et des parois (4, 8), au moins une cellule photovoltaïque (10) disposée dans le caisson, et au moins un dispositif de gestion de l'humidité, au moins une première paroi (4, 8) parmi lesdites parois comportant une partie principale contenue dans un plan, ledit dispositif de gestion de l'humidité comportant un logement défini entre ladite première paroi (4, 8) et des moyens d'occultation solidaires de ladite première paroi (4, 8), un matériau absorbant l'humidité (12, 112, 212, 312) disposé dans ledit logement, au moins une partie du matériau absorbant l'humidité (12, 112, 212, 312) étant située d'un côté dudit plan contenant les moyens d'occultation, lesdits moyens d'occultation étant disposés en regard du matériau absorbant l'humidité de sorte à ménager un passage entre lesdits moyens d'occultation et le matériau absorbant l'humidité et de sorte que l'air contenu dans le volume du caisson circule dans le passage entre les moyens d'occultation et le matériau absorbant l'humidité et retourne dans le volume du caisson.

2. Module solaire selon la revendication 1 dans lequel le logement est défini par la partie principale de ladite première paroi (4, 8), le matériau absorbant l'humidité (12, 112) étant entièrement situé du même côté du plan.

3. Module solaire selon la revendication 1 dans lequel la première paroi (4, 8) comporte une partie formée par une dépression (219, 319), ladite dépression (219, 319) définissant avec les moyens d'occultation ledit logement, le matériau absorbant l'humidité (212, 312) étant contenu en partie dans ladite dépression (219, 319), la dépression (219, 319) étant avantageusement réalisée par emboutissage.

4. Module Solaire selon l'une des revendications 1 à 3, dans lequel le caisson comporte au moins une paroi latérale (4) et une paroi inférieure (8) opposée au fond supérieur, la première paroi étant formée par la paroi inférieure (8).

5. Module Solaire selon l'une des revendications 1 à 3, dans lequel le caisson comporte des parois latérales (4) et une paroi inférieure (8) opposée au fond supérieur, la première paroi étant formée par une desdites parois latérales (4).

6. Module solaire selon l'une des revendications 1 à 5, dans lequel le dispositif de gestion de l'humidité comporte un capot (14, 114, 214, 314) portant les moyens d'occultation, les moyens d'occultation étant au moins formés par une plaque d'occultation (14.1, 114.1, 214.1, 314.1).

7. Module solaire selon la revendication 6, dans lequel le capot comporte des parties de fixation (14.2, 114.2, 214.2, 314.2) de la plaque d'occultation (14.1, 114.1, 214.1, 314.1) à la première paroi (4 ,8), la plaque d'occultation (14.1, 114.1, 214.1, 314.1) étant pleine et lesdites parties de fixation (14.2, 114.2, 214.2, 314.2) étant ajourées de sorte à permettre l'établissement d'un flux d'air entre la plaque d'occultation (14.1, 114.1, 214.1, 314.1)et le matériau absorbant l'humidité (12, 112, 212, 312).

8. Module solaire selon la revendication 6 ou 7, dans lequel le capot (14, 214, 314) comporte au moins une plaque d'occultation (14.1, 214.1, 314.1) destinée à recevoir le flux solaire et une partie intérieure (18, 218, 318) en regard du matériau de stockage, un espace étant ménagé entre ladite partie intérieure (18, 218, 318) et ladite plaque d'occultation (14.1, 214.1, 314.1).

9. Module Solaire selon la revendication 8, dans lequel un matériau d'isolation thermique différent de l'air est prévu entre la partie d'occultation et la partie intérieure.

10. Module Solaire selon la revendication 8 ou 9, dans lequel la partie intérieure (218, 318) est ajourée de sorte à permettre à l'air situé dans l'espace entre la partie intérieure (218, 318) et la plaque d'occultation (214.1, 314.1) d'entrer en contact avec le matériau absorbant l'humidité (212, 312).

11. Module solaire selon l'une des revendications 8 à 10, dans lequel la partie intérieure (318) est telle qu'elle exerce un effort sur le matériau de stockage (312) en direction de la première paroi latérale (4, 8), la partie intérieure (318) étant avantageusement sous forme de lames solidaires par une extrémité longitudinale à la plaque d'occultation (314.1) et est en appui contre le matériau absorbant l'humidité (312).

12. Module Solaire selon l'une des revendications 8 à 11 en combinaison avec la revendication 7, dans lequel la plaque d'occultation (14.1, 114.1, 214.1, 314.1), la partie intérieure (18, 218, 318) et les parties de fixation (14.2, 114.2, 214.2, 314.2) sont d'un seul tenant.

13. Module Solaire selon l'une des revendications 8 à 12 en combinaison avec la revendication 7, dans lequel les parties de fixation (114.2) forment les moyens de maintien du matériau absorbant l'humidité (112), au moins un matériau d'isolation thermique étant avantageusement prévu entre le matériau absorbant l'humidité (112) et les moyens de maintien.

14. Module Solaire selon l'une des revendications 1 à 13, dans lequel au moins un matériau d'isolation thermique est prévu entre le matériau absorbant l'humidité et la première paroi.

15. Module Solaire selon l'une des revendications 8 à 12, dans lequel la distance entre la première paroi du logement et une face intérieure de la partie intérieure est égale à au moins 2 mm et dans lequel la surface libre de passage d'air est au moins égale à 10% du produit entre une largeur active du matériau absorbant l'humidité et la distance entre la partie principale de la première paroi du logement et une face intérieure du capot.

## Patentansprüche

1. Konzentrations-Solarmodul, umfassend einen Kasten (2), welcher umfasst: einen oberen Boden (6), welcher durch ein optisches System gebildet ist, und Wände (4, 8), wenigstens eine in dem Kasten angeordnete Photovoltaikzelle (10) und wenigstens eine Feuchtigkeits-Steuervorrichtung, wobei wenigstens eine erste Wand (4, 8) aus den Wänden einen in einer Ebene enthaltenen Hauptteil umfasst, wobei die Feuchtigkeits-Steuervorrichtung eine Aufnahme umfasst, welche zwischen der ersten Wand (4, 8) und mit der ersten Wand (4, 8) verbundenen Bedeckungsmitteln definiert ist, wobei ein Feuchtigkeits-Absorptionsmaterial (12, 112, 212, 312) in der Aufnahme angeordnet ist, wobei wenigstens ein Teil des Feuchtigkeits-Absorptionsmaterials (12, 112, 212, 312) auf einer Seite der Ebene angeordnet ist, welche die Bedeckungsmittel enthält, wobei die Bedeckungsmittel gegenüber des Feuchtigkeits-Absorptionsmaterials derart angeordnet sind, dass ein Durchgang zwischen den Bedeckungsmitteln und dem Feuchtigkeits-Absorptionsmaterial derart erzeugt wird, dass die in dem Volumen des Kastens enthaltene Luft in dem Durchgang zwischen den Bedeckungsmitteln und dem Feuchtigkeits-Absorptionsmaterial zirkuliert und in das Volumen des Kastens zurückkehrt.

2. Solarmodul nach Anspruch 1, wobei die Aufnahme durch den Hauptteil der ersten Wand (4, 8) definiert ist, wobei das Feuchtigkeits-Absorptionsmaterial (12, 112) vollständig an der gleichen Seite der Ebene angeordnet ist.

3. Solarmodul nach Anspruch 1, wobei die erste Wand (4, 8) einen Abschnitt umfasst, welcher durch eine Vertiefung (219, 319) gebildet ist, wobei die Vertiefung (219, 319) zusammen mit den Bedeckungsmitteln die Aufnahme definiert, wobei das Feuchtigkeits-Absorptionsmaterial (212, 312) teilweise in der Vertiefung (219, 319) enthalten ist, wobei die Vertiefung (219, 319) vorzugsweise durch Tiefziehen hergestellt ist.

4. Solarmodul nach einem der Ansprüche 1 bis 3, wobei der Kasten wenigstens eine laterale Wand (4) und eine untere Wand (8) gegenüber dem oberen Boden umfasst, wobei die erste Wand durch die untere Wand (8) gebildet ist.

5. Solarmodul nach einem der Ansprüche 1 bis 3, wobei der Kasten laterale Wände (4) und eine untere Wand (8) gegenüber dem oberen Boden umfasst, wobei die erste Wand durch eine der lateralen Wände (4) gebildet ist.

6. Solarmodul nach einem der Ansprüche 1 bis 5, wobei die Feuchtigkeits-Steuervorrichtung eine Haube (14, 114, 214, 314) umfasst, welche die Bedeckungsmittel trägt, wobei die Bedeckungsmittel wenigstens durch eine Bedeckungsplatte (14.1, 114.1, 214.1, 314.1) gebildet sind.

7. Solarmodul nach Anspruch 6, wobei die Haube Teile zur Befestigung (14.2, 114.2, 214.2, 314.2) der Bedeckungsplatte (14.1, 114.1, 214.1, 314.1) an der ersten Wand (4, 8) umfasst, wobei die Bedeckungsplatte (14.1, 114.1, 214.1, 314.1) durchgehend ist und die Teile zur Befestigung (14.2, 114.2, 214.2, 314.2) derart durchbrochen sind, dass ein Entstehen eines Luftstroms zwischen der Bedeckungsplatte (14.1, 114.1, 214.1, 314.1) und dem Feuchtigkeits-Absorptionsmaterial (12, 112, 212, 312) erlaubt wird.

8. Solarmodul nach Anspruch 6 oder 7, wobei die Haube (14, 214, 314) wenigstens eine Bedeckungsplatte (14.1, 214.1, 314.1), welche dazu vorgesehen ist, die Sonneneinstrahlung aufzunehmen, und einen inneren Teil (18, 218, 318) gegenüber dem Lagerungsmaterial umfasst, wobei ein Raum zwischen dem inneren Teil (18, 218, 318) und der Bedeckungsplatte (14.1, 214.1, 314.1) erzeugt wird.

9. Solarmodul nach Anspruch 8, wobei ein von Luft verschiedenes Wärmeisolations-Material zwischen dem Bedeckungsteil und dem inneren Teil vorgesehen ist.

10. Solarmodul nach Anspruch 8 oder 9, wobei der innere Teil (218, 318) derart durchbrochen ist, dass es in dem Raum zwischen dem inneren Teil (218, 318) und der Bedeckungsplatte (214.1, 314.1) befindlicher Luft erlaubt wird, in Kontakt mit dem Feuchtigkeits-Absorptionsmaterial zu kommen.

11. Solarmodul nach einem der Ansprüche 8 bis 10, wobei der innere Teil (318) derart ist, dass er eine Kraft auf das Lagerungsmaterial (312) in Richtung der ersten lateralen Wand (4, 8) ausübt, wobei der innere Teil (318) vorzugsweise in Form von Klingen ist, welche mit einem longitudinalen Ende an der Bedeckungsplatte (314.1) verbunden sind, und in Anlage gegen das Feuchtigkeits-Absorptionsmaterial (312) ist.

12. Solarmodul nach einem der Ansprüche 8 bis 11 in Kombination mit Anspruch 7, wobei die Bedeckungsplatte (14.1, 114.1, 214.1, 314.1), der innere Teil (18, 218, 318) und die Befestigungsteile (14.2, 114.2, 214.2, 314.2) einstückig sind.

13. Solarmodul nach einem der Ansprüche 8 bis 12 in Kombination mit Anspruch 7, wobei die Befestigungsteile (114.2) die Mittel zum Halten des Feuchtigkeits-Absorptionsmaterials (112) bilden, wobei vorzugsweise wenigstens ein Wärmeisolations-Material zwischen dem Feuchtigkeits-Absorptionsmaterial (112) und den Mitteln zum Halten vorgesehen ist.

14. Solarmodul nach einem der Ansprüche 1 bis 13, wobei wenigstens ein Wärmeisolationsmaterial zwischen dem Feuchtigkeits-Absorptionsmaterial und der ersten Wand vorgesehen ist.

15. Solarmodul nach einem der Ansprüche 8 bis 12, wobei der Abstand zwischen der ersten Wand der Aufnahme und einer inneren Fläche des inneren Teils wenigstens gleich 2 mm ist und wobei die freie Oberfläche des Luftdurchgangs wenigstens gleich 10% des Produkts aus einer aktiven Größe des Feuchtigkeits-Absorptionsmaterials und dem Abstand zwischen der Hauptteil der ersten Wand der Aufnahme und einer inneren Fläche der Haube ist.

## Claims

1. Concentrating solar module comprising a box (2) comprising an upper bottom (6) composed of an optical system, and walls (4, 8), at least one photovoltaic cell (10) placed in the box, and at least one humidity management device, at least one first wall (4, 8) among said walls comprising a principal part contained in a plane, said humidity management device comprising a housing defined between said first wall (4, 8) and occultation means fixed to said first wall (4, 8), a moisture-absorbing material (12, 112, 212, 312) placed in said housing, at least part of the moisture-absorbing material (12, 112, 212, 312) being located on one side of said plane containing the occultation means, said occultation means being arranged facing the moisture-absorbing material so as to form a passage between said occultation means and the moisture-absorbing material and such that air contained in the volume of the box circulates in the passage between the occultation means and the moisture-absorbing material and returns into the volume of the box.

2. Solar module according to claim 1 in which the housing is defined by the principal part of said first wall (4, 8), the moisture-absorbing material (12, 112) being entirely located on the same side of the plane.

3. Solar module according to claim 1 in which the first wall (4, 8) comprises a part formed by a depression (219, 319), said depression (219, 319) combined with the occultation means defining said housing, the moisture-absorbing material (212, 312) being partly contained in said depression (219, 319), the depression (219, 319) being advantageously made by stamping.

4. Solar module according to one of claims 1 to 3, in which the box comprises at least one side wall (4) and a lower bottom (8) opposite the upper bottom, the first wall being formed by the lower bottom wall.

5. Solar module according to one of claims 1 to 3, in which the box comprises side walls (4) and a lower bottom (8) opposite the upper bottom, the first wall being formed by one of said side walls (4).

6. Solar module according to one of claims 1 to 5, in which the humidity management device comprises a cover (14, 114, 214, 314) supporting the occultation means, the occultation means being formed at least by an occultation plate (14.1, 114.1, 214.1, 314.1).

7. Solar module according to claim 8, in which the cover comprises parts (14.2, 114.2, 214.2, 314.2) for fixing the occultation plate (14.1, 114.1, 214.1, 314.1) to the first wall (4,8), the occultation plate (14.1, 114.1, 214.1, 314.1) being solid and said attachment parts (14.2, 114.2, 214.2, 314.2) being perforated so as to enable an air flow to be set up between the occultation plate (14.1, 114.1, 214.1, 314.1) and the moisture-absorbing material (12, 112, 212, 312).

8. Solar module according to claim 6 or 7, in which the cover (14, 214, 314) comprises at least one occultation plate (14.1, 214.1, 314.1) that will collect the solar flux and an inner part (18, 218, 318) facing the storage material, a space being arranged between said inner part (18, 218, 318) and said occultation plate (14.1, 214.1, 314.1).

9. Solar module according to claim 8, in which a thermal insulation material other than air is provided between the occultation part and the inner part.

10. Solar module according to claim 8 or 9, in which the inner part (218, 318) is perforated so as to allow air located in the space between the inner part (218, 318) and the occultation plate (214.1, 314.1) to come into contact with the moisture-absorbing material (212, 312).

11. Solar module according to one of claims 8 to 10, in which the inner part (318) is such that it applies a force on the storage material (312) towards the first side wall (4, 8), the inner part (318) being advantageously formed from strips fixed at a longitudinal end to the occultation plate (314.1) and bears in contact with the moisture-absorbing material (312).

12. Solar module according to one of claims 8 to 11 combined with claim 7, in which the occultation plate (14.1, 114.1, 214.1, 314.1), the inner part (18, 218, 318) and the attachment parts (14.2, 114.2, 214.2, 314.2) are made from a single piece.

13. Solar module according to one of claims 8 to 12 combined with claim 7, in which the attachment parts (114.2) form the retaining means of the moisture-absorbing material (112), at least one thermal insulation material being provided between the moisture-absorbing material (112) and the retaining means.

14. Solar module according to one of claims 1 to 13, in which at least one thermal insulation material is provided between the moisture-absorbing material and the first wall.

15. Solar module according to one of claims 8 to 12, in which the distance between the first wall of the housing and an inner face of the inner part is equal to at least 2 mm and in which the free air passage area is equal to at least 10% of the product of an active width of the moisture-absorbing material and the distance between the main part of the first wall of the housing and an inner face of the cover.
